# EUROPEAN PATENT APPLICATION

(11) **EP 4 793 405 A1**
(43) Date of publication of application: **19.08.2026**
(21) Application number: 24876904.4
(22) Date of filing: 03.07.2024
(51) Int. Cl.: C23C 18/36, C23C 18/42, C23C 18/52, H01L 23/12

(54) **PLATING FILM FOR METAL SINTERING BONDING, METHOD FOR MANUFACTURING SAME, AND SEMICONDUCTOR MOUNTING SUBSTRATE**

(30) Priority: 13.10.2023 JP 2023177387
(71) Applicant: OKUNO CHEMICAL INDUSTRIES CO., LTD., Osaka-shi, Osaka 541-0045 (JP); The University of Osaka, Osaka 565-0871 (JP)
(72) Inventor: SETO, Hiroki, Osaka-shi, Osaka 538-0044 (JP); NAGAMURA, Haruki, Osaka-shi, Osaka 538-0044 (JP); HASHIZUME, Kei, Osaka-shi, Osaka 538-0044 (JP); HSIEH, Ming-chun, Suita-shi, Osaka 565-0871 (JP); SUGANUMA, Katsuaki, Suita-shi, Osaka 565-0871 (JP); CHEN, Chuantong, Suita-shi, Osaka 565-0871 (JP); ZHANG, Zheng, Suita-shi, Osaka 565-0871 (JP); SUETAKE, Aiji, Suita-shi, Osaka 565-0871 (JP)
(74) Representative: Müller-Boré & Partner Patentanwälte PartG mbB
(86) International application number: PCT/JP2024/024010
(87) International publication number: WO 2025/079303

(57) **Abstract**

Provided is a plating film suitable for metal sintering bonding, which has excellent heat resistance and thermal shock resistance. A plating film for metal sintering bonding having (A) an electroless nickel-phosphorus plating film, the electroless nickel-phosphorus plating film (A) having a phosphorus content of 4 mass% or less based on 100 mass% of the electroless nickel-phosphorus plating film.

## Description

### Technical Field

The present invention relates to a plating film, a method for manufacturing the same, and a semiconductor mounting substrate.

### Background Art

In recent years, next-generation power modules incorporating wide-bandgap power semiconductor devices, such as SiC and GaN, have been used. Since such next-generation power modules can operate in high-temperature environments of, for example, 200°C or higher, high heat resistance is required for their peripheral components as well.

Conventionally, solder has been used to bond semiconductor devices to substrates; however, it has the problems of poor heat resistance and thermal shock resistance.

Metal sintering bonding using silver or copper particles has attracted attention as a bonding technology to replace solder. However, performing metal sintering bonding requires surface treatment of components to be bonded, such as substrates, and films formed by the surface treatment are also required to have heat resistance.

The present inventors found that electroless nickel alloy plating is suitable as a surface treatment for silver sintering bonding or copper sintering bonding. Electroless nickel alloy plating includes electroless nickel-phosphorus plating, electroless nickel-boron plating, and the like. In particular, electroless nickel-phosphorus plating films are being put to practical use in a wide range of fields.

However, commonly used electroless nickel-phosphorus plating films with a phosphorus content of 6 to 12 mass% (see PTL 1) have poor heat resistance and thermal shock resistance, and become cracked when used in high-temperature environments, resulting in the problem that they cannot be used as peripheral components for next-generation power modules.

### Citation List

### Patent Literature

PTL 1: JP2023-090169A

### Summary of Invention

### Technical Problem

An object of the present invention is to provide a plating film suitable for metal sintering bonding, which has excellent heat resistance and thermal shock resistance.

### Solution to Problem

As a result of extensive research in order to achieve the above object, the present inventors found that the object can be achieved by a plating film for metal sintering bonding having (A) an electroless nickel-phosphorus plating film, wherein the electroless nickel-phosphorus plating film (A) has a phosphorus content within a specified range. Thus, the present invention has been completed.

Specifically, the present invention relates to the following plating film, method for manufacturing the same, and semiconductor mounting substrate.
1. A plating film for metal sintering bonding having (A) an electroless nickel-phosphorus plating film,
   the electroless nickel-phosphorus plating film (A) having a phosphorus content of 4 mass% or less based on 100 mass% of the electroless nickel-phosphorus plating film.
2. The plating film for metal sintering bonding according to Item 1, wherein the electroless nickel-phosphorus plating film (A) has a sulfur content of less than 0.0005 mass% based on 100 mass% of the electroless nickel-phosphorus plating film.
3. The plating film for metal sintering bonding according to Item 1 or 2, wherein the electroless nickel-phosphorus plating film (A) has a sulfur content of 0.0001 mass% or less based on 100 mass% of the electroless nickel-phosphorus plating film.
4. The plating film for metal sintering bonding according to any one of Items 1 to 3, wherein the electroless nickel-phosphorus plating film (A) has a thickness of 0.1 to 20 µm.
5. The plating film for metal sintering bonding according to any one of Items 1 to 4, further having (B) an electroless silver plating film or an electroless gold plating film on the electroless nickel-phosphorus plating film (A).
6. The plating film for metal sintering bonding according to Item 5, wherein the electroless silver plating film or electroless gold plating film (B) has a thickness of 0.02 to 2 µm.
7. The plating film for metal sintering bonding according to Item 5 or 6, further having (C) a barrier metal layer between the electroless nickel-phosphorus plating film (A) and the electroless silver plating film or electroless gold plating film (B).
8. The plating film for metal sintering bonding according to Item 7, wherein the barrier metal layer (C) is an electroless palladium plating film or an electroless palladium-phosphorus plating film.
9. The plating film for metal sintering bonding according to any one of Items 1 to 8, which is for a metal sintered material containing silver and/or copper.
10. A method for manufacturing a plating film for metal sintering bonding, which forms a plating film for metal sintering bonding on a substrate,
   the method comprising (1) step 1 of bringing an electroless nickel-phosphorus plating solution into contact with a surface of a substrate to form (A) an electroless nickel-phosphorus plating film on the substrate,
   the electroless nickel-phosphorus plating film (A) having a phosphorus content of 4 mass% or less based on 100 mass% of the electroless nickel-phosphorus plating film.
11. The manufacturing method according to Item 10, further comprising (2) step 2 of bringing an electroless silver plating solution or an electroless gold plating solution into contact with a surface of the electroless nickel-phosphorus plating film to form (B) an electroless silver plating film or an electroless gold plating film on the electroless nickel-phosphorus plating film (A).
12. A semiconductor mounting substrate comprising a plating film for metal sintering bonding having (A) an electroless nickel-phosphorus plating film laminated on a substrate,
   the semiconductor mounting substrate having a semiconductor device on the plating film for metal sintering bonding via a metal sintered material layer,
   the electroless nickel-phosphorus plating film (A) having a phosphorus content of 4 mass% or less based on 100 mass% of the electroless nickel-phosphorus plating film.

### Advantageous Effects of Invention

The plating film for metal sintering bonding of the present invention has excellent heat resistance and thermal shock resistance. Therefore, the plating film can be suitably used for metal sintering bonding in next-generation power modules. In addition, the method for manufacturing a plating film of the present invention can produce a plating film that has excellent heat resistance and thermal shock resistance and can be suitably used for metal sintering bonding. Furthermore, the semiconductor mounting substrate of the present invention has excellent heat resistance and thermal shock resistance.

### Description of Embodiments

The present invention will be described in detail below.

In the plating film for metal sintering bonding of the present invention, when the electroless nickel-phosphorus plating film (A) is laminated on the substrate, the side opposite the side in contact with the substrate is also referred to as the "top" or "front surface," and the opposite side, i.e., the side of the electroless nickel-phosphorus plating film (A) in contact with the substrate, is also referred to as the "bottom" or "back surface."

### 1. Plating Film for Metal Sintering Bonding

The plating film for metal sintering bonding of the present invention (hereafter also referred to simply as the "plating film") is a plating film having (A) an electroless nickel-phosphorus plating film (hereafter also referred to as the "layer (A)"), the electroless nickel-phosphorus plating film (A) having a phosphorus content of 4 mass% or less based on 100 mass% of the electroless nickel-phosphorus plating film. Since the plating film of the present invention has the layer (A), the layer (A) can suppress the oxidation of the substrate, and can dissipate heat generated from a semiconductor device while securing the semiconductor device via a metal sintered material, making the plating film suitable for mounting semiconductor devices. In addition, because the layer (A) has a phosphorus content of 4 mass% or less based on 100 mass% of the electroless nickel-phosphorus plating film, the plating film of the present invention has excellent heat resistance and thermal shock resistance and can be suitably used for metal sintering bonding.

The details of each plating film that constitutes the plating film for metal sintering bonding of the present invention will be described below.

### (A) Electroless Nickel-Phosphorus Plating Film

The plating film for metal sintering bonding of the present invention has (A) an electroless nickel-phosphorus plating film.

The phosphorus content of the electroless nickel-phosphorus plating film is 4 mass% or less based on 100 mass% of the electroless nickel-phosphorus plating film. If the phosphorus content exceeds 4 mass%, the heat resistance and thermal shock resistance are poor, and cracks appear on the plating film, resulting in insufficient adhesion to the metal sintered material and making the plating film unsuitable for mounting semiconductor devices. The phosphorus content is preferably 3 mass% or less, more preferably 2 mass% or less, and even more preferably 1 mass% or less. The lower limit of the phosphorus content is not particularly limited, and may be 0.1 mass%, 0.2 mass%, or 0.5 mass%. The phosphorus content of the electroless nickel-phosphorus plating film can be reduced by changing the electroless nickel-phosphorus plating composition or the plating conditions.

The sulfur content of the layer (A) is preferably less than 0.0005 mass%, more preferably 0.0002 mass% or less, and even more preferably 0.0001 mass% or less, based on 100 mass% of the electroless nickel-phosphorus plating film (A). Particularly preferably, the layer (A) does not contain sulfur, i.e., has a sulfur content of 0 mass%. Since the sulfur content of the layer (A) is within the above range, the heat resistance and thermal shock resistance of the plating film of the present invention are further improved, and the occurrence of cracks can be suppressed, making the plating film suitable for mounting semiconductor devices via metal sintered materials. The sulfur content can be reduced by reducing the amount of raw materials containing divalent sulfur in the composition of the electroless nickel-phosphorus plating solution used to form the layer (A).

The thickness of the layer (A) is not particularly limited, but is preferably 0.1 to 20 µm, more preferably 0.2 to 10 µm, and even more preferably 0.5 to 5 µm.

### (B) Electroless Silver Plating Film or Electroless Gold Plating Film

The plating film for metal sintering bonding of the present invention may have (B) an electroless silver plating film or an electroless gold plating film (hereafter also referred to as the "layer (B)") on the layer (A). Since the plating film for metal sintering bonding of the present invention has the layer (B), the adhesion to the metal sintered material is further improved, and it is possible to dissipate heat generated from a semiconductor device while securing the semiconductor device via a metal sintered material, making the plating film more suitable for mounting semiconductor devices.

The thickness of the layer (B) is not particularly limited, and is preferably 0.02 to 2 µm from the viewpoint of being able to secure the semiconductor device more firmly via the metal sintered material, and being more likely to dissipate heat generated from the semiconductor device while securing the semiconductor device.

When the layer (B) is an electroless silver plating film, the thickness of the layer (B) is preferably 0.02 to 1 µm, and more preferably 0.05 to 0.5 µm. When the layer (B) is an electroless gold plating film, the thickness of the layer (B) is preferably 0.02 to 1 µm, and more preferably 0.03 to 0.2 µm.

### (C) Barrier Metal Layer

The plating film for metal sintering bonding of the present invention may further have (C) a barrier metal layer (hereafter also referred to as the "layer (C)") between the layers (A) and (B). Since the plating film for metal sintering bonding of the present invention has the layer (C), it is possible to further suppress the surface diffusion of the underlying metal and the corrosion of the nickel-phosphorus plating film due to electroless silver plating or electroless gold plating, thereby further improving the adhesion to the metal sintered material.

The layer (C) is not particularly limited, and any known plating film can be used. Examples of the layer (C) include an electroless palladium plating film, an electroless palladium-phosphorus plating film, an electroless platinum plating film, an electroless cobalt-phosphorus plating film, and an electroless cobalt-boron plating film. Preferred among these are an electroless palladium plating film and an electroless palladium-phosphorus plating film, from the viewpoint of being able to suppress the surface diffusion of the underlying metal and the corrosion of the nickel-phosphorus plating film due to electroless silver plating or electroless gold plating.

When the layer (C) contains phosphorus, for example, as in an electroless palladium-phosphorus plating film, the phosphorus content of the layer (C) is preferably 0.1 to 2.0 mass%, and more preferably 0.5 to 1.5 mass%, based on 100 mass% of the layer (C). Since the phosphorus content of the layer (C) is within the above range, it is possible to further suppress the surface diffusion of the underlying metal and the corrosion of the nickel-phosphorus plating film due to electroless silver plating or electroless gold plating.

### Characteristics of Plating Film for Metal Sintering Bonding

The thickness of the plating film for metal sintering bonding of the present invention is not particularly limited, and is preferably 1 to 10 µm, more preferably 1.5 to 8 µm, and even more preferably 2 to 5 µm. Since the thickness of the plating film for metal sintering bonding is within the above range, the mounted semiconductor can be secured more firmly, and the oxidation is further suppressed.

Due to the above configuration, the plating film for metal sintering bonding of the present invention described above has excellent heat resistance and thermal shock resistance. Therefore, the plating film can be suitably used for metal sintering bonding in next-generation power modules. In particular, the plating film for metal sintering bonding of the present invention can be suitably used for silver sintering bonding or copper sintering bonding. That is, the plating film for metal sintering bonding of the present invention is suitable for use as a metal sintered material containing silver and/or copper.

### 2. Method for Manufacturing Plating Film for Metal Sintering Bonding

The method for manufacturing a plating film for metal sintering bonding of the present invention is a method for manufacturing a plating film for metal sintering bonding, which forms a plating film for metal sintering bonding on a substrate,
the method comprising (1) step 1 of bringing an electroless nickel-phosphorus plating solution into contact with a surface of a substrate to form (A) an electroless nickel-phosphorus plating film on the substrate,
the electroless nickel-phosphorus plating film (A) having a phosphorus content of 4 mass% or less based on 100 mass% of the electroless nickel-phosphorus plating film.
The manufacturing method of the present invention can produce the plating film for metal sintering bonding of the present invention that has excellent heat resistance and thermal shock resistance and can be suitably used for metal sintering bonding.

Each step will be described below.

### Step 1

Step 1 is a step of bringing an electroless nickel-phosphorus plating solution into contact with a surface of a substrate to form (A) an electroless nickel-phosphorus plating film on the substrate.

The substrate (article to be plated) used in step 1 may be a substrate used for electronic components such as semiconductors and circuits. Such substrates include printed wiring boards, ceramic substrates, silicon substrates, metal substrates, and the like. Specific examples include semiconductor chips (mainly back electrodes) such as SiC, GaN, and Si, metal lead frames, insulating heat dissipation circuit substrates (ceramic substrates) such as DBC (direct bonded copper) substrates, DBA (direct bonded aluminum) substrates, and AMB (active metal brazing) substrates, and heat dissipation substrates such as heat sinks. Examples of the material of the plated portion of the article to be plated include copper, copper alloys, aluminum, and aluminum alloys.

The electroless nickel-phosphorus plating solution used in step 1 is not particularly limited as long as the phosphorus content of the electroless nickel-phosphorus plating film produced in step 1 can be adjusted to 4 mass% or less based on 100 mass% of the electroless nickel-phosphorus plating film. Such an electroless nickel-phosphorus plating solution is, for example, an electroless nickel-phosphorus plating solution containing a water-soluble nickel compound, a reducing agent, and a complexing agent, and optionally other additives. An example of such an electroless nickel-phosphorus plating solution will be described below.

### Water-Soluble Nickel Compound

The water-soluble nickel compound contained in the electroless nickel-phosphorus plating solution used in the manufacturing method of the present invention is not particularly limited, and any known nickel compound used in electroless nickel-phosphorus plating solutions can be used. Preferred examples of the water-soluble nickel compound include water-soluble nickel inorganic salts such as nickel sulfate, nickel chloride, nickel hypophosphite, and nickel carbonate; water-soluble nickel organic salts such as nickel acetate and nickel malate; and hydrates thereof.

The water-soluble nickel compounds may be used singly or in combination of two or more.

The concentration of the water-soluble nickel compound in the electroless nickel-phosphorus plating solution is not particularly limited and can be appropriately adjusted within the range in which an electroless nickel-phosphorus plating film can be formed. The concentration of the water-soluble nickel compound is preferably, for example, about 0.01 g/L to 100 g/L, more preferably 0.5 g/L to 50 g/L, and even more preferably 1 g/L to 10 g/L, in terms of nickel metal. If the concentration of the water-soluble nickel compound is less than 0.01 g/L in terms of nickel metal, the deposition rate may decrease, and if the concentration exceeds 100 g/L, the bath stability may decrease. Thus, the above range is preferred.

### Reducing Agent

The reducing agent is preferably at least one selected from the group consisting of hypophosphorous acid and hypophosphites (e.g., sodium, potassium, and ammonium salts).

The reducing agents may be used singly or in combination of two or more.

The concentration of the reducing agent (e.g., hypophosphorous acid, hypophosphites, and hydrates thereof) in the electroless nickel-phosphorus plating solution is preferably about 0.5 g/L to 40 g/L, more preferably about 1 g/L to 20 g/L, and even more preferably about 2 g/L to 15 g/L. Since the upper limit of the concentration is within the above range, the phosphorus content of the electroless nickel-phosphorus plating film formed can be easily adjusted to 4 mass% or less. Further, since the lower limit of the concentration is within the above range, the deposition properties of electroless nickel-phosphorus plating can be made more stable.

### Complexing Agent

The electroless nickel-phosphorus plating solution preferably contains glycine, gluconate, or the like as a complexing agent. The gluconate is preferably, for example, a sodium salt, a potassium salt, or an ammonium salt.

Other preferred complexing agents include monocarboxylic acids such as formic acid and acetic acid, or salts thereof (e.g., sodium, potassium, and ammonium salts); dicarboxylic acids such as malonic acid, succinic acid, adipic acid, maleic acid, and fumaric acid, or salts thereof (e.g., sodium, potassium, and ammonium salts); hydroxycarboxylic acids such as malic acid, lactic acid, glycolic acid, and citric acid, or salts thereof (e.g., sodium, potassium, and ammonium salts); ethylenediaminediacetic acid, ethylenediaminetetraacetic acid, or salts thereof (e.g., sodium, potassium, and ammonium salts); and amino acids such as alanine and arginine.

The complexing agents may be used singly or in combination of two or more.

The concentration of the complexing agent in the electroless nickel-phosphorus plating solution is not particularly limited and can be appropriately adjusted. The electroless nickel-phosphorus plating solution preferably contains a complexing agent in an amount of about 1 g/L to 100 g/L, more preferably about 2 g/L to 50 g/L, and even more preferably about 5 g/L to 30 g/L. If the concentration of the complexing agent is less than 1 g/L, the bath stability may decrease, and if the concentration exceeds 100 g/L, the deposition rate may decrease. Thus, the above range is preferred.

### Stabilizer, Sulfur-Based Additive, pH Adjuster, Surfactant, etc.

In addition to the above components, the electroless nickel-phosphorus plating solution may contain known additives used in electroless nickel-phosphorus plating solutions, if necessary. Examples of additives include stabilizers, sulfur-based additives, pH adjusters, and surfactants.

Examples of stabilizers include lead compounds (e.g., lead nitrate and lead acetate), cadmium compounds (e.g., cadmium nitrate and cadmium acetate), thallium compounds (e.g., thallium sulfate and thallium nitrate), antimony compounds (e.g., antimony chloride and potassium antimonyl tartrate), tellurium compounds (e.g., telluric acid and tellurium chloride), chromium compounds (e.g., chromium oxide and chromium sulfate), iron compounds (e.g., iron sulfate and iron chloride), manganese compounds (e.g., manganese sulfate and manganese nitrate), bismuth compounds (e.g., bismuth nitrate and bismuth acetate), tin compounds (e.g., tin sulfate and tin chloride), selenium compounds (e.g., selenic acid and selenious acid), cyanides (e.g., methyl cyanide and isopropyl cyanide), and iodine compounds (e.g., potassium iodide).

The stabilizers may be used singly or in combination of two or more.

The concentration of the stabilizer in the electroless nickel-phosphorus plating solution is not particularly limited, and can be, for example, about 0.1 mg/L to 500 mg/L. For the purpose of improving the stability of the electroless nickel-phosphorus plating solution, the concentration of the stabilizer is preferably about 0.1 mg/L or more. If the concentration of the stabilizer exceeds 500 mg/L, there may be areas where no plating film is formed (non-deposited areas). Thus, the above range is preferred.

The sulfur-based additive for use is preferably, for example, a divalent sulfur-based compound such as thiourea. From the viewpoint of further reducing the sulfur content of the electroless nickel-phosphorus plating film, it is preferable to add the minimum amount necessary of the sulfur-based additive or not add it at all.

The pH adjuster for use is preferably, for example, an acid such as hydrochloric acid, sulfuric acid, or phosphoric acid; or an alkali such as sodium hydroxide, potassium hydroxide, or aqueous ammonia.

The pH of the electroless nickel-phosphorus plating solution is preferably about 3 to 12, and more preferably about 4 to 9. The pH of the plating bath can be adjusted using any of the pH adjusters described above. If the pH is less than 3, no deposition may occur, and if the pH exceeds 12, the bath stability may decrease. Thus, the above range is preferred.

As the surfactant, various surfactants such as nonionic, anionic, cationic and amphoteric surfactants can be used. Examples include aromatic or aliphatic sulfonic acid alkali salts, and aromatic or aliphatic sulfonic acid alkali metal salts. The surfactants can be used singly or in combination of two or more. When a mixture of two or more surfactants is used, the mixing ratio is not particularly limited and can be appropriately determined.

The concentration of the surfactant in the electroless nickel-phosphorus plating solution is not particularly limited, and can be, for example, about 0.01 mg/L to 1000 mg/L. For the purpose of further enhancing the pit prevention effect of the electroless nickel-phosphorus plating solution, the concentration of the surfactant is preferably about 0.01 mg/L or more. If the concentration of the surfactant is 1000 mg/L or less, the deterioration of the deposition properties due to foaming is further suppressed.

### Electroless Nickel-Phosphorus Plating Method

In step 1, the electroless nickel-phosphorus plating solution is brought into contact with the surface of the substrate.

The method for bringing the surface of the substrate into contact with the electroless plating solution is not particularly limited and can be carried out according to a conventional method. In step 1, a preferred method is, for example, immersing the substrate, which is an article to be plated, in the electroless nickel-phosphorus plating solution.

The plating conditions (e.g., solution temperature and plating time) are not particularly limited as long as the conditions allow for the formation of an electroless nickel-phosphorus plating film, and can be appropriately determined.

The temperature of the electroless nickel-phosphorus plating solution in step 1 can be appropriately determined depending on the composition of the electroless nickel-phosphorus plating solution and other factors. For example, the temperature of the electroless nickel-phosphorus plating solution in the plating step can be preferably about 25°C or higher, more preferably about 40°C to 100°C, and even more preferably about 45°C to 95°C. If the solution temperature is lower than 25°C, the deposition rate of the plating film is slow, which may reduce production efficiency. Thus, the above range is preferred.

The treatment time in step 1 is not particularly limited, and may be the time required to form an electroless plating film of the required thickness on the article to be plated. Specifically, the treatment time in the plating step can be appropriately determined depending on the composition of the plating bath, the type of article to be plated, and other factors, and can be, for example, preferably about 1 minute to 120 minutes, and more preferably 3 minutes to 60 minutes.

The electroless nickel-phosphorus plating film formed on the substrate in step 1 is the electroless nickel-phosphorus plating film (A) present in the plating film for metal sintering bonding of the present invention, wherein the phosphorus content is 4 mass% or less based on 100 mass% of the electroless nickel-phosphorus plating film. The characteristics and other properties of the electroless nickel-phosphorus plating film (A) formed on the substrate in step 1 are the same as the characteristics and other properties described for the electroless nickel-phosphorus plating film (A) in the plating film for metal sintering bonding of the present invention.

An example of the method for adjusting the phosphorus content of the electroless nickel-phosphorus plating film (A) to 4 mass% or less is (i) adjusting the content of the reducing agent in the electroless nickel-phosphorus plating solution. If the content of the reducing agent in the electroless nickel-phosphorus plating solution increases, the phosphorus content of the electroless nickel-phosphorus plating film to be formed increases, and if the content of the reducing agent in the electroless nickel-phosphorus plating solution decreases, the phosphorus content of the electroless nickel-phosphorus plating film decreases. Another example of the adjustment method is (ii) adjusting the pH of the electroless nickel-phosphorus plating solution in step 1. If the pH decreases, the phosphorus content of the electroless nickel-phosphorus plating film to be formed increases, and if the pH increases, the phosphorus content of the electroless nickel-phosphorus plating film decreases. Still another example of the adjustment method is (iii) adjusting the temperature of the electroless nickel-phosphorus plating solution in step 1. If the solution temperature rises, the phosphorus content of the electroless nickel-phosphorus plating film to be formed decreases, and if the solution temperature drops, the phosphorus content of the electroless nickel-phosphorus plating film increases.

The method for adjusting the sulfur content of the electroless nickel-phosphorus plating film (A) is, for example, adjusting the content of a divalent sulfur-based compound, such as thiourea, in the electroless nickel-phosphorus plating solution. If the content of the divalent sulfur-based compound in the electroless nickel-phosphorus plating solution increases, the sulfur content of the electroless nickel-phosphorus plating film to be formed increases, and if the content of the divalent sulfur-based compound in the electroless nickel-phosphorus plating solution decreases, the sulfur content of the electroless nickel-phosphorus plating film decreases.

Through step 1 described above, the electroless nickel-phosphorus plating film (A) is formed on the substrate.

### Step 2

The manufacturing method of the present invention may further have, after step 1, (2) step 2 of bringing an electroless silver plating solution or an electroless gold plating solution into contact with the surface of the electroless nickel-phosphorus plating film to form (B) an electroless silver plating film or an electroless gold plating film on the electroless nickel-phosphorus plating film (A).

The electroless silver plating solution or electroless gold plating solution used in step 2 is not particularly limited, and any conventionally known plating solution can be used. The electroless silver plating solution and electroless gold plating solution used in step 2 will be described below.

### Electroless Silver Plating Solution

The electroless silver plating solution is not particularly limited, and usable examples include reduction deposition type, displacement-reduction deposition type, and displacement deposition type electroless silver plating solutions. The reduction deposition type or displacement-reduction deposition type electroless silver plating solution for use can be an electroless silver plating solution containing a silver compound, a reducing agent, and a complexing agent, and optionally other additives. Further, the displacement deposition type electroless silver plating solution for use can be an electroless silver plating solution containing a silver compound and a complexing agent, and optionally other additives. An example of such an electroless silver plating solution will be described below.

### Silver Compound

The silver compound is not particularly limited as long as it is a water-soluble silver compound, and any known silver compound used in electroless silver plating solutions can be used. Examples of the silver compound include inorganic salts such as silver nitrate, silver sulfate, and silver iodide; and organic salts such as silver acetate and silver methanesulfonate.

The silver compounds may be used singly or in combination of two or more.

The concentration of the silver compound in the electroless silver plating solution is not particularly limited as long as an electroless silver plating film can be formed, and can be appropriately adjusted. The concentration of the silver compound is preferably, for example, about 0.01 g/L to 20 g/L, more preferably about 0.1 to 10 g/L, and even more preferably about 0.2 g/L to 5 g/L, in terms of silver metal. If the concentration of the silver compound is less than 0.01 g/L in terms of silver metal, the deposition rate may decrease, and if the concentration exceeds 20 g/L, the bath stability may decrease. Thus, the above range is preferred.

### Reducing Agent

The reducing agent is preferably at least one selected from the group consisting of water-soluble aldehyde compounds, water-soluble hydrazine derivatives, hydrogenated boron compounds, hypophosphorous acid, phosphorous acid, ascorbic acid, and salts thereof (e.g., sodium, potassium, and ammonium salts). In the case of a displacement deposition type electroless silver plating solution, it does not need to contain a reducing agent.

The reducing agents may be used singly or in combination of two or more.

The concentration of the reducing agent in the electroless silver plating solution is preferably about 0.5 g/L to 15 g/L, more preferably about 1 g/L to 13 g/L, and even more preferably about 1.5 g/L to 10 g/L.

### Complexing Agent

The electroless silver plating solution preferably contains, as a complexing agent, an amide compound, an imide compound, a thiosulfate compound, a sulfite compound, a sulfur-containing compound (a sulfur-containing compound other than thiosulfate and sulfite compounds), a nitrogen-containing compound (a nitrogen-containing compound other than amide and imide compounds), or the like; and more preferably an amide compound or an imide compound.

Examples of amide compounds include cyclic amide compounds such as benzamide, N-methylpyrrolidone, N-ethylpyrrolidone, N-vinylpyrrolidone, pyrrolidone, N-butylpyrrolidone, 5-methylpyrrolidone, and N-methylpiperidinone; and chain amide compounds, such as acetamide, formamide, N,N-dimethylformamide, N-methyl-N-phenylformamide, and N,N-diphenylformamide. These may be used singly or in combination of two or more. Preferred among these are chain amide compounds, and more preferred are acetamide and formamide.

The imide compound is not particularly limited, and examples include preferably cyclic imide compounds such as hydantoin, 5,5-dimethylhydantoin, 1-methylhydantoin, 1,3-dimethylhydantoin, glutarimide, and succinimide; more preferably hydantoin, 5,5-dimethylhydantoin, 1-methylhydantoin, succinimide, 1,3-methylhydantoin, and glutarimide; and even more preferably 1-methylhydantoin and succinimide.

The complexing agents may be used singly or in combination of two or more.

The concentration of the complexing agent in the electroless silver plating solution is not particularly limited and can be appropriately adjusted. The electroless silver plating solution preferably contains the complexing agent in an amount of about 1 g/L to 100 g/L, more preferably about 2 g/L to 50 g/L, and even more preferably about 5 g/L to 30 g/L. If the concentration of the complexing agent is less than 1 g/L, the bath stability may decrease, and if the concentration exceeds 100 g/L, the deposition rate may decrease. Thus, the above range is preferred.

### Stabilizer, pH Adjuster, Surfactant, etc.

In addition to the above components, the electroless silver plating solution may contain known additives used in electroless silver plating solutions, if necessary. Examples of additives include stabilizers, pH adjusters, and surfactants.

Examples of stabilizers include lead compounds (e.g., lead nitrate and lead acetate), cadmium compounds (e.g., cadmium nitrate and cadmium acetate), thallium compounds (e.g., thallium sulfate and thallium nitrate), antimony compounds (e.g., antimony chloride and potassium antimonyl tartrate), tellurium compounds (e.g., telluric acid and tellurium chloride), chromium compounds (e.g., chromium oxide and chromium sulfate), iron compounds (e.g., iron sulfate and iron chloride), manganese compounds (e.g., manganese sulfate and manganese nitrate), bismuth compounds (e.g., bismuth nitrate and bismuth acetate), tin compounds (e.g., tin sulfate and tin chloride), selenium compounds (e.g., selenic acid and selenious acid), cyanides (e.g., methyl cyanide and isopropyl cyanide), and iodine compounds (e.g., potassium iodide).

The stabilizers may be used singly or in combination of two or more.

The concentration of the stabilizer in the electroless silver plating solution is not particularly limited, and can be, for example, about 0.1 mg/L to 500 mg/L. For the purpose of improving the stability of the electroless silver plating solution, the concentration of the stabilizer is preferably about 0.1 mg/L or more. If the concentration of the stabilizer exceeds 500 mg/L, there may be areas where no plating film is formed (non-deposited areas). Thus, the above range is preferred.

The pH adjuster for use is preferably, for example, an acid such as nitric acid, sulfuric acid, or phosphoric acid; or an alkali such as sodium hydroxide, potassium hydroxide, or aqueous ammonia.

The pH of the electroless silver plating solution is preferably about 1 to 12, and more preferably about 1.5 to 11. The pH of the plating bath can be adjusted using any of the pH adjusters described above. If the pH is less than 1, no deposition may occur, and if the pH exceeds 12, the bath stability may decrease. Thus, the above range is preferred.

As the surfactant, various surfactants such as nonionic, anionic, cationic and amphoteric surfactants can be used. Examples include aromatic or aliphatic sulfonic acid alkali salts, and aromatic or aliphatic sulfonic acid alkali metal salts. The surfactants can be used singly or in combination of two or more. When a mixture of two or more surfactants is used, the mixing ratio is not particularly limited and can be appropriately determined.

The concentration of the surfactant in the electroless silver plating solution is not particularly limited, and can be, for example, about 0.01 mg/L to 1000 mg/L. For the purpose of further enhancing the pit prevention effect of the electroless silver plating solution, the concentration of the surfactant is preferably about 0.01 mg/L or more. If the concentration of the surfactant is 1000 mg/L or less, the deterioration of the deposition properties due to foaming is further suppressed.

### Electroless Silver Plating Method

In step 2, the method for forming an electroless silver plating film on the electroless nickel-phosphorus plating film is not particularly limited, and examples include a method in which an electroless silver plating solution is brought into contact with the surface of the electroless nickel-phosphorus plating film formed in step 1.

The method for bringing the surface of the electroless nickel-phosphorus plating film into contact with the electroless silver plating solution is not particularly limited and can be carried out according to a conventional method. In step 2, a preferred method is, for example, immersing the substrate on which the electroless nickel-phosphorus plating film has been formed in an electroless silver plating solution.

The plating conditions (e.g., solution temperature and plating time) are not particularly limited as long as the conditions allow for the formation of an electroless silver plating film, and can be appropriately determined.

The temperature of the electroless silver plating solution in step 2 can be appropriately determined depending on the composition of the electroless silver plating solution and other factors. For example, the temperature of the electroless silver plating solution in the plating step can be preferably about 25°C or higher, more preferably about 30°C to 80°C, and even more preferably about 40°C to 75°C. If the solution temperature is lower than 25°C, the deposition rate of the plating film is slow, which may reduce production efficiency. Thus, the above range is preferred.

The treatment time in step 2 is not particularly limited, and may be the time required to form an electroless silver plating film of the required thickness. Specifically, the treatment time in the plating step can be appropriately determined depending on the composition of the electroless silver plating solution and other factors, and can be, for example, preferably about 1 minute to 40 minutes, and more preferably 3 minutes to 20 minutes.

The electroless silver plating film formed in step 2 is an electroless silver plating film as the layer (B) that may be present in the plating film for metal sintering bonding of the present invention. The characteristics and other properties of the electroless silver plating film formed on the substrate in step 2 are the same as the characteristics and other properties described for the layer (B) in the plating film for metal sintering bonding of the present invention.

### Electroless Gold Plating Solution

The electroless gold plating solution is not particularly limited, and usable examples include reduction deposition type, displacement-reduction deposition type, and displacement deposition type electroless gold plating solutions. The reduction deposition type or displacement-reduction deposition type electroless gold plating solution for use can be an electroless gold plating solution containing a gold compound, a reducing agent, and a complexing agent, and optionally other additives. Further, the displacement deposition type electroless gold plating solution for use can be an electroless gold plating solution containing a gold compound and a complexing agent, and optionally other additives. An example of such an electroless gold plating solution will be described below.

### Gold Compound

The gold compound is not particularly limited as long as it is a water-soluble gold compound, and any known gold compound used in electroless gold plating solutions can be used. Examples of the gold compound include potassium gold sulfite, sodium gold sulfite, ammonium gold sulfite, potassium gold cyanide, sodium gold cyanide, and ammonium gold cyanide.

The gold compounds may be used singly or in combination of two or more.

The concentration of the gold compound in the electroless gold plating solution is not particularly limited as long as an electroless gold plating film can be formed, and can be appropriately adjusted. The concentration of the gold compound is preferably, for example, about 0.01 g/L to 10 g/L, more preferably 0.2 g/L to 5 g/L, and even more preferably 0.5 g/L to 2 g/L, in terms of gold metal. If the concentration of the gold compound is less than 0.01 g/L in terms of gold metal, the deposition rate may decrease, and if the concentration exceeds 10 g/L, the cost increases. Thus, the above range is preferred.

### Reducing Agent

The reducing agent is also not particularly limited, and reducing agents similar to those used in known electroless gold plating solutions can be used. Usable examples include hydrazines such as hydrazine hydrate, hydrazine sulfate, neutral hydrazine sulfate, hydrazine maleate, and salts thereof; hydroxylamines and salts thereof; hydrazine derivatives such as adipic acid dihydrazide, isophthalic acid dihydrazide, and isopropyl hydrazine sulfate; ascorbic acid and salts thereof (e.g., sodium, potassium, and ammonium salts); hydrogenated boron compounds such as trimethylamine borane (TMAB) and dimethylamine borane (DMAB); thiourea; hypophosphorous acid and salts thereof (e.g., sodium, potassium, and ammonium salts).

The reducing agents may be used singly or in combination of two or more. In the case of a displacement deposition type electroless gold plating solution, it does not need to contain a reducing agent.

The concentration of the reducing agent in the electroless gold plating solution is preferably about 1 g/L to 15 g/L, more preferably about 2 g/L to 13 g/L, and even more preferably about 3 g/L to 10 g/L.

### Complexing Agent

The complexing agent is not particularly limited, and any complexing agent used in known electroless gold plating solutions can be used. Usable examples include sulfites such as sodium sulfite, potassium sulfite, and ammonium sulfite; cyanides such as sodium cyanide and potassium cyanide; thiosulfates such as sodium thiosulfate, potassium thiosulfate, and ammonium thiosulfate; inorganic acids such as phosphoric acid and boric acid, and salts thereof (e.g., sodium, potassium, and ammonium salts); hydroxycarboxylic acids such as citric acid, gluconic acid, tartaric acid, lactic acid, and malic acid, and salts thereof (e.g., sodium, potassium, and ammonium salts); amine compounds such as ethylenediamine and triethanolamine; aminocarboxylic acids such as glycine, alanine, ethylenediaminetetraacetic acid, and nitrilotriacetic acid, and salts thereof (e.g., sodium, potassium, and ammonium salts); phosphonic acids such as aminotrimethylenephosphonic acid, 1-hydroxyethylidene-1,1-diphosphonic acid, ethylenediaminetetramethylenephosphonic acid, and diethylenetriaminepenta(methylenephosphonic acid), and salts thereof (e.g., sodium, potassium, and ammonium salts).

The complexing agents may be used singly or in combination of two or more.

The concentration of the complexing agent in the electroless gold plating solution is not particularly limited and can be appropriately adjusted. The electroless gold plating solution preferably contains the complexing agent in an amount of about 1 g/L to 100 g/L, more preferably about 2 g/L to 50 g/L, and even more preferably about 5 g/L to 30 g/L. If the concentration of the complexing agent is less than 1 g/L, the bath stability may decrease, and if the concentration exceeds 100 g/L, the deposition rate may decrease. Thus, the above range is preferred.

### Stabilizer, pH Adjuster, Surfactant, etc.

In addition to the above components, the electroless gold plating solution may contain known additives used in electroless gold plating solutions, if necessary. Examples of additives include stabilizers, pH adjusters, and surfactants.

Examples of stabilizers include lead compounds (e.g., lead nitrate and lead acetate), cadmium compounds (e.g., cadmium nitrate and cadmium acetate), thallium compounds (e.g., thallium sulfate and thallium nitrate), antimony compounds (e.g., antimony chloride and potassium antimonyl tartrate), tellurium compounds (e.g., telluric acid and tellurium chloride), chromium compounds (e.g., chromium oxide and chromium sulfate), iron compounds (e.g., iron sulfate and iron chloride), manganese compounds (e.g., manganese sulfate and manganese nitrate), bismuth compounds (e.g., bismuth nitrate and bismuth acetate), tin compounds (e.g., tin sulfate and tin chloride), selenium compounds (e.g., selenic acid and selenious acid), cyanides (e.g., methyl cyanide and isopropyl cyanide), and iodine compounds (e.g., potassium iodide).

The stabilizers may be used singly or in combination of two or more.

The concentration of the stabilizer in the electroless gold plating solution is not particularly limited, and can be, for example, about 0.1 mg/L to 500 mg/L. For the purpose of improving the stability of the electroless gold plating solution, the concentration of the stabilizer is preferably about 0.1 mg/L or more. If the concentration of the stabilizer exceeds 500 mg/L, there may be areas where no plating film is formed (non-deposited areas). Thus, the above range is preferred.

The pH adjuster for use is preferably, for example, an acid such as hydrochloric acid, sulfuric acid, or phosphoric acid; or an alkali such as sodium hydroxide, potassium hydroxide, or aqueous ammonia.

The pH of the electroless gold plating solution is preferably about 3 to 12, and more preferably about 4 to 9. The pH of the plating bath can be adjusted using any of the pH adjusters described above. If the pH is less than 3, no deposition may occur, and if the pH exceeds 12, the bath stability may decrease. Thus, the above range is preferred.

As the surfactant, various surfactants such as nonionic, anionic, cationic and amphoteric surfactants can be used. Examples include aromatic or aliphatic sulfonic acid alkali salts, and aromatic or aliphatic sulfonic acid alkali metal salts. The surfactants can be used singly or in combination of two or more. When a mixture of two or more surfactants is used, the mixing ratio is not particularly limited and can be appropriately determined.

The concentration of the surfactant in the electroless gold plating solution is not particularly limited, and can be, for example, about 0.01 mg/L to 1000 mg/L. For the purpose of further enhancing the pit prevention effect of the electroless gold plating solution, the concentration of the surfactant is preferably about 0.01 mg/L or more. If the concentration of the surfactant is 1000 mg/L or less, the deterioration of the deposition properties due to foaming is further suppressed.

### Electroless Gold Plating Method

In step 2, the method for forming an electroless gold plating film on the electroless nickel-phosphorus plating film is not particularly limited, and examples include a method in which an electroless gold plating solution is brought into contact with the surface of the electroless nickel-phosphorus plating film formed in step 1.

The method for bringing the surface of the electroless nickel-phosphorus plating film into contact with the electroless gold plating solution is not particularly limited and can be carried out according to a conventional method. In step 2, a preferred method is, for example, immersing the substrate on which the electroless nickel-phosphorus plating film has been formed in an electroless gold plating solution.

The plating conditions (e.g., solution temperature and plating time) are not particularly limited as long as the conditions allow for the formation of an electroless gold plating film, and can be appropriately determined.

The temperature of the electroless gold plating solution in step 2 can be appropriately determined depending on the composition of the electroless gold plating solution and other factors. For example, the temperature of the electroless gold plating solution in the plating step can be preferably about 25°C or higher, more preferably about 40°C to 90°C, and even more preferably about 45°C to 85°C. If the solution temperature is lower than 25°C, the deposition rate of the plating film is slow, which may reduce production efficiency. Thus, the above range is preferred.

The treatment time in step 2 is not particularly limited, and may be the time required to form an electroless gold plating film of the required thickness. Specifically, the treatment time in the plating step can be appropriately determined depending on the composition of the electroless gold plating solution and other factors, and can be, for example, preferably about 1 minute to 40 minutes, and more preferably 3 minutes to 20 minutes.

The electroless gold plating film formed in step 2 is an electroless gold plating film as the layer (B) that may be present in the plating film for metal sintering bonding of the present invention. The characteristics and other properties of the electroless gold plating film formed in step 2 are the same as the characteristics and other properties described for the layer (B) in the plating film for metal sintering bonding of the present invention.

Through step 2 described above, the electroless silver plating film or electroless gold plating film (B) is formed on the electroless nickel-phosphorus plating film (A).

### Barrier Metal Layer-Forming Step

The manufacturing method of the present invention may further have, between steps 1 and 2, a barrier metal layer-forming step of bringing a plating solution for forming a barrier metal layer into contact with the surface of the electroless nickel-phosphorus plating film to form (C) a barrier metal layer on the electroless nickel-phosphorus plating film (A). Since the method has the barrier metal layer-forming step, the barrier metal layer (C) can be formed between the layers (A) and (B).

The barrier metal layer (C) is not particularly limited, and any known plating film can be used. Examples of the layer (C) include an electroless palladium plating film, an electroless palladium-phosphorus plating film, an electroless platinum plating film, an electroless cobalt-phosphorus plating film, and an electroless cobalt-boron plating film. Preferred among these are an electroless palladium plating film and an electroless palladium-phosphorus plating film, from the viewpoint of being able to further suppress the surface diffusion of the underlying metal, and the corrosion of the electroless nickel-phosphorus plating film due to electroless silver plating or electroless gold plating.

The following will describe an electroless palladium plating solution and an electroless palladium-phosphorus plating solution for forming an electroless palladium plating film and an electroless palladium-phosphorus plating film as barrier metal layers.

### Electroless Palladium Plating Solution and Electroless Palladium-Phosphorus Plating Solution

Examples of the electroless palladium plating solution and electroless palladium-phosphorus plating solution include an electroless palladium plating solution and an electroless palladium-phosphorus plating solution each containing a palladium compound, a reducing agent, and a complexing agent, and optionally other additives. Examples of the electroless palladium plating solution and electroless palladium-phosphorus plating solution will be described below.

### Palladium Compound

The palladium compound is not particularly limited as long as it is a water-soluble palladium compound, and any known palladium compound used in electroless palladium plating solutions and electroless palladium-phosphorus plating solutions can be used. Examples of the palladium compound include palladium chloride, palladium sulfate, palladium acetate, and tetraammine palladium dichloride.

The palladium compounds may be used singly or in combination of two or more.

The concentration of the palladium compound in the electroless palladium plating solution and electroless palladium-phosphorus plating solution is not particularly limited as long as their plating films can be formed, and can be appropriately adjusted. The concentration of the palladium compound is preferably, for example, about 0.01 g/L to 10 g/L, more preferably 0.2 g/L to 5 g/L, and even more preferably 0.5 g/L to 2 g/L, in terms of palladium metal. If the concentration of the palladium compound is less than 0.01 g/L in terms of palladium metal, the deposition rate may decrease, and if the concentration exceeds 10 g/L, the bath stability may decrease. Thus, the above range is preferred.

### Reducing Agent

The reducing agent used in the electroless palladium plating solution is preferably formic acid, a water-soluble aldehyde compound, a water-soluble hydrazine derivative, or a boron hydride compound. Further, the reducing agent used in the electroless palladium-phosphorus plating solution is preferably at least one selected from the group consisting of hypophosphorous acid and hypophosphites (e.g., sodium, potassium, and ammonium salts), and phosphorous acid and phosphites (e.g., sodium, potassium, and ammonium salts).

The reducing agents may be used singly or in combination of two or more.

The concentration of the reducing agent in the electroless palladium plating solution and electroless palladium-phosphorus plating solution is preferably about 1 g/L to 100 g/L, more preferably about 2 g/L to 50 g/L, and even more preferably about 5 g/L to 40 g/L.

### Complexing Agent

The complexing agent is not particularly limited, and any complexing agent used in known electroless palladium plating solutions and electroless palladium-phosphorus plating solutions can be used. Usable examples of complexing agents include amines such as ethylenediamine and diethylenetriamine; aminopolycarboxylic acids such as ethylenediaminediacetic acid, ethylenediaminetetraacetic acid, and diethylenetriaminepentaacetic acid, or salts thereof (e.g., sodium, potassium, and ammonium salts); amino acids such as glycine, alanine, iminodiacetic acid, nitrilotriacetic acid, L-glutamic acid, L-glutamic acid diacetate, L-aspartic acid, and taurine, or salts thereof (e.g., sodium, potassium, and ammonium salts); aminotrimethylenephosphonic acid, 1-hydroxyethylidene-1,1-diphosphonic acid, and ethylenediaminetetramethylenephosphonic acid, or salts thereof (e.g., sodium, potassium, and ammonium salts); monocarboxylic acids such as acetic acid, or salts thereof (e.g., sodium, potassium, and ammonium salts); dicarboxylic acids such as malonic acid, succinic acid, adipic acid, maleic acid, and fumaric acid, or salts thereof (e.g., sodium, potassium, and ammonium salts); and hydroxycarboxylic acids such as malic acid, lactic acid, glycolic acid, and citric acid, or salts thereof (e.g., sodium, potassium, and ammonium salts).

The complexing agents may be used singly or in combination of two or more.

The concentration of the complexing agent in the electroless palladium plating solution and electroless palladium-phosphorus plating solution is not particularly limited and can be appropriately adjusted. The electroless palladium plating solution and electroless palladium-phosphorus plating solution preferably contain the complexing agent in an amount of about 1 g/L to 100 g/L, more preferably about 2 g/L to 50 g/L, and even more preferably about 5 g/L to 30 g/L. If the concentration of the complexing agent is less than 1 g/L, the bath stability may decrease, and if the concentration exceeds 100 g/L, the deposition rate may decrease. Thus, the above range is preferred.

### Stabilizer, pH Adjuster, Surfactant, etc.

In addition to the above components, the electroless palladium plating solution and electroless palladium-phosphorus plating solution may contain known additives used in electroless palladium plating solutions and electroless palladium-phosphorus plating solutions, if necessary. Examples of additives include stabilizers, pH adjusters, and surfactants.

Examples of stabilizers include lead compounds (e.g., lead nitrate and lead acetate), cadmium compounds (e.g., cadmium nitrate and cadmium acetate), thallium compounds (e.g., thallium sulfate and thallium nitrate), antimony compounds (e.g., antimony chloride and potassium antimonyl tartrate), tellurium compounds (e.g., telluric acid and tellurium chloride), chromium compounds (e.g., chromium oxide and chromium sulfate), iron compounds (e.g., iron sulfate and iron chloride), manganese compounds (e.g., manganese sulfate and manganese nitrate), bismuth compounds (e.g., bismuth nitrate and bismuth acetate), tin compounds (e.g., tin sulfate and tin chloride), selenium compounds (e.g., selenic acid and selenious acid), cyanides (e.g., methyl cyanide and isopropyl cyanide), and iodine compounds (e.g., potassium iodide).

The stabilizers may be used singly or in combination of two or more.

The concentration of the stabilizer in the electroless palladium plating solution and electroless palladium-phosphorus plating solution is not particularly limited, and can be, for example, about 0.1 mg/L to 500 mg/L. For the purpose of improving the stability of the electroless palladium plating solution and electroless palladium-phosphorus plating solution, the concentration of the stabilizer is preferably about 0.1 mg/L or more. If the concentration of the stabilizer exceeds 500 mg/L, there may be areas where no plating film is formed (non-deposited areas). Thus, the above range is preferred.

The pH adjuster for use is preferably, for example, an acid such as hydrochloric acid, sulfuric acid, or phosphoric acid; or an alkali such as sodium hydroxide, potassium hydroxide, or aqueous ammonia.

The pH of the electroless palladium plating solution and electroless palladium-phosphorus plating solution is preferably about 3 to 12, and more preferably about 4 to 9. The pH of the plating bath can be adjusted using any of the pH adjusters described above. If the pH is less than 3, no deposition may occur, and if the pH exceeds 12, the bath stability may decrease. Thus, the above range is preferred.

As the surfactant, various surfactants such as nonionic, anionic, cationic and amphoteric surfactants can be used. Examples include aromatic or aliphatic sulfonic acid alkali salts, and aromatic or aliphatic sulfonic acid alkali metal salts. The surfactants can be used singly or in combination of two or more. When a mixture of two or more surfactants is used, the mixing ratio is not particularly limited and can be appropriately determined.

The concentration of the surfactant in the electroless palladium plating solution and electroless palladium-phosphorus plating solution is not particularly limited, and can be, for example, about 0.01 mg/L to 1000 mg/L. For the purpose of further enhancing the pit prevention effect of the electroless palladium plating solution and electroless palladium-phosphorus plating solution, the concentration of the surfactant is preferably about 0.01 mg/L or more. If the concentration of the surfactant is 1000 mg/L or less, the deterioration of the deposition properties due to foaming is further suppressed.

### Barrier Metal Layer-Forming Method

In the barrier metal layer-forming step, the method for forming, for example, an electroless palladium plating film and an electroless palladium-phosphorus plating film on the electroless nickel-phosphorus plating film is not particularly limited, and examples include a method in which an electroless palladium plating solution and an electroless palladium-phosphorus plating solution are brought into contact with the surface of the electroless nickel-phosphorus plating film formed in step 1.

The method for bringing the surface of the electroless nickel-phosphorus plating film into contact with the electroless palladium plating solution and electroless palladium-phosphorus plating solution is not particularly limited and can be carried out according to a conventional method. In the barrier metal layer-forming step, a preferred method is, for example, immersing the substrate on which the electroless nickel-phosphorus plating film has been formed in an electroless palladium plating solution and an electroless palladium-phosphorus plating solution.

The plating conditions (e.g., solution temperature and plating time) are not particularly limited as long as the conditions allow for the formation of an electroless palladium plating layer and an electroless palladium-phosphorus plating layer, and can be appropriately determined.

The temperature of the electroless palladium plating solution and electroless palladium-phosphorus plating solution in the barrier metal layer-forming step can be appropriately determined depending on the compositions of the electroless palladium plating solution and electroless palladium-phosphorus plating solution and other factors. For example, the temperature of the electroless palladium plating solution and electroless palladium-phosphorus plating solution in the plating step can be preferably about 25°C or higher, more preferably about 40°C to 90°C, and even more preferably about 45°C to 85°C. If the solution temperature is lower than 25°C, the deposition rate of the plating film is slow, which may reduce production efficiency. Thus, the above range is preferred.

The treatment time in the barrier metal layer-forming step is not particularly limited, and may be the time required to form an electroless palladium plating layer or electroless palladium-phosphorus plating layer of the required thickness. Specifically, the treatment time in the plating step can be appropriately determined depending on the composition of the electroless palladium plating solution or electroless palladium-phosphorus plating solution and other factors, and can be, for example, preferably about 1 minute to 40 minutes, and more preferably 3 minutes to 20 minutes.

The electroless palladium plating film and electroless palladium-phosphorus plating film formed in the barrier metal layer-forming step are barrier metal layers as the layers (C) that may be present in the plating film for metal sintering bonding of the present invention. The characteristics and other properties of the barrier metal layer formed in the barrier metal layer-forming step are the same as the characteristics and other properties described for the layer (C) in the plating film for metal sintering bonding of the present invention.

Through the barrier metal layer-forming step described above, the barrier metal layer (C) is formed on the electroless nickel-phosphorus plating film (A). Since the method has the barrier metal layer-forming step, the barrier metal layer (C) can be formed between the layers (A) and (B).

### 3. Semiconductor Mounting Substrate

The semiconductor mounting substrate of the present invention is a semiconductor mounting substrate comprising a plating film for metal sintering bonding laminated on a substrate, wherein the plating film for metal sintering bonding has (A) an electroless nickel-phosphorus plating film,
wherein a semiconductor device is provided on the plating film for metal sintering bonding via a metal sintered material layer, and
wherein the electroless nickel-phosphorus plating film (A) has a phosphorus content of 4 mass% or less based on 100 mass% of the electroless nickel-phosphorus plating film.

In the semiconductor mounting substrate of the present invention, the plating film for metal sintering bonding of the present invention described above is formed on a substrate, and a semiconductor device is bonded onto the plating film for metal sintering bonding via a metal sintered material layer.

The characteristics and other properties of the plating film for metal sintering bonding are the same as the characteristics and other properties described in the explanation of the plating film for metal sintering bonding of the present invention.

In the semiconductor mounting substrate of the present invention, the semiconductor device is bonded via the metal sintered material layer.

As the sintered material for forming the metal sintered material layer, a sintered material paste containing metal powder and an organic solvent can be used.

The metal powder contained in the sintered material paste is not particularly limited, and any known metal powder conventionally used in sintered materials can be used. Examples of such metals include silver, copper, and gold. Preferred among these are copper and silver powders, and more preferred is silver powder.

The average particle size of the metal powder is not particularly limited, and any metal powder of known size can be used. The average particle size of the metal powder is preferably on the order of several µm to mm.

The organic solvent contained in the sintered material paste is not particularly limited, and any known organic solvent used in conventional sintered material pastes can be used. Examples of such organic solvents include methanol, ethanol, 1-propanol, 2-propanol, 2-butanol, 1-butanol, 2-methyl-1-propanol, 2-methyl-2-propanol, 1-pentanol, 1-octanol, toluene, diethylene glycol, triethylene glycol, ethylene glycol monomethyl ether, diethylene glycol monomethyl ether, diethylene glycol monoethyl ether, propylene glycol monomethyl ether, diethylene glycol monohexyl ether, terpineol, diethylene glycol methyl ether acetate terpineol, diisopropyl ether, tetrahydrofuran, and 1,4-dioxane. Preferred among these are toluene, diethylene glycol, triethylene glycol, diethylene glycol monomethyl ether, terpineol, and diethylene glycol methyl ether acetate terpineol.

The heating temperature during metal sintering bonding is not particularly limited, and may be any heating temperature generally used for metal sintering bonding, which is about 100 to 450°C.

The pressure during metal sintering bonding may be non-pressurized or pressurized. In the case of pressurization, the pressure is preferably about 0.1 MPa to 50 MPa, and more preferably about 0.2 MPa to 5 MPa.

The configuration of the semiconductor mounting substrate of the present invention may be such that at least a plating film for metal sintering bonding having (A) an electroless nickel-phosphorus plating film is laminated on a substrate, and a semiconductor device is provided on the plating film for metal sintering bonding via a metal sintered material layer. That is, the configuration of the semiconductor mounting substrate of the present invention may be at least substrate/plating film for metal sintering bonding/metal sintered material layer/semiconductor device, or may be a configuration further having a plating film for metal sintering bonding on the semiconductor device side as well. That is, the configuration of the semiconductor mounting substrate of the present invention may be substrate/plating film for metal sintering bonding/metal sintered material layer/plating film for metal sintering bonding/semiconductor device, and more specifically substrate/layer (A)/metal sintered material layer/layer (A)/semiconductor device.

The semiconductor mounting substrate of the present invention has excellent heat resistance and thermal shock resistance because the plating film for metal sintering bonding of the present invention is formed on a substrate, and a semiconductor device is bonded onto the plating film for metal sintering bonding via a metal sintered material layer. The semiconductor mounting substrate of the present invention as described above can be suitably used as a next-generation power module that can operate in high-temperature environments.

Due to the above configuration, the plating film for metal sintering bonding of the present invention has excellent heat resistance and thermal shock resistance. Therefore, the plating film can be suitably used for metal sintering bonding, and can also be used to form a bonded assembly between a substrate (e.g., an insulating heat dissipation circuit substrate such as a DBC or DBA substrate) and another substrate (e.g., a heat dissipation plate or a heat sink). Examples of the configuration of such a bonded assembly include substrate (e.g., an insulating heat dissipation circuit substrate such as a DBC or DBA substrate)/plating film for metal sintering bonding/metal sintered material layer/plating film for metal sintering bonding/substrate (e.g., a heat dissipation plate or a heat sink).

### Examples

The present invention will be described in more detail below with reference to Examples and Comparative Examples. However, the present invention is not limited to the Examples.

In the Examples and Comparative Examples, a copper bulk material (30 × 30 × 3 mm) was used as a substrate (article to be plated). The substrate was pretreated by degreasing, acid activation, and the application of a palladium catalyst.

### Example 1. Article to Be Plated: Electroless Nickel-Phosphorus Plating Film: Electroless Silver Plating Film

### Formation of Electroless Nickel-Phosphorus Plating Film

An article to be plated was brought into contact with an electroless nickel-phosphorus plating solution having the following composition under the following plating conditions to form an electroless nickel-phosphorus plating film on the article to be plated.

### Electroless Nickel-Phosphorus Plating Composition

As a basic composition, 22.5 g/L of nickel sulfate·6H₂O, 20 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 20 minutes

### Formation of Electroless Silver Plating Film

The electroless nickel-phosphorus plating film formed on the article to be plated was brought into contact with an electroless silver plating solution having the following composition under the following plating conditions to form an electroless silver plating film on the electroless nickel-phosphorus plating film.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 60°C
Contact time with plating solution: 20 minutes

As described above, a plating film for metal sintering bonding was produced in which the following electroless nickel-phosphorus plating film and electroless silver plating film were formed in this order on the article to be plated.
- Electroless nickel-phosphorus plating film: phosphorus content 4 mass%, sulfur content 0.0003 mass%, thickness 4 µm
- Electroless silver plating film: thickness 0.2 µm

### Example 2. Article to Be Plated: Electroless Nickel-Phosphorus Plating Film: Electroless Silver Plating Film

The electroless nickel-phosphorus plating composition and plating conditions in Example 1 were changed to the following, thereby producing a plating film for metal sintering bonding in which the following electroless nickel-phosphorus plating film and electroless silver plating film were formed in this order on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes
   - Electroless nickel-phosphorus plating film: phosphorus content 2 mass%, sulfur content 0.0003 mass%, thickness 4 µm
   - Electroless silver plating film: thickness 0.2 µm

### Example 3. Article to Be Plated: Electroless Nickel-Phosphorus Plating Film: Electroless Silver Plating Film

The electroless nickel-phosphorus plating composition and plating conditions in Example 1 were changed to the following, thereby producing a plating film for metal sintering bonding in which the following electroless nickel-phosphorus plating film and electroless silver plating film were formed in this order on the article to be plated.

### Electroless Nickel-Phosphorus Plating Composition

As a basic composition, 22.5 g/L of nickel sulfate·6H₂O, 8 g/L of sodium hypophosphite, 20 g/L of glycine, and 0.5 mg/L of lead acetate were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes
   - Electroless nickel-phosphorus plating film: phosphorus content 2 mass%, sulfur content 0.0001 mass%, thickness 4 µm
   - Electroless silver plating film: thickness 0.2 µm

### Example 4. Article to Be Plated: Electroless Nickel-Phosphorus Plating Film: Electroless Silver Plating Film

The electroless nickel-phosphorus plating composition and plating conditions in Example 1 were changed to the following, thereby producing a plating film for metal sintering bonding in which the following electroless nickel-phosphorus plating film and electroless silver plating film were formed in this order on the article to be plated.

### Electroless Nickel-Phosphorus Plating Composition

As a basic composition, 22.5 g/L of nickel sulfate·6H₂O, 8 g/L of sodium hypophosphite, 20 g/L of glycine, and 0.5 mg/L of lead acetate were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 3.5 minutes
   - Electroless nickel-phosphorus plating film: phosphorus content 2 mass%, sulfur content 0.0001 mass%, thickness 0.5 µm
   - Electroless silver plating film: thickness 0.2 µm

### Example 5. Article to Be Plated: Electroless Nickel-Phosphorus Plating Film: Electroless Silver Plating Film

The electroless silver plating composition and plating conditions in Example 2 were changed to the following, thereby producing a plating film for metal sintering bonding in which the following electroless nickel-phosphorus plating film and electroless silver plating film were formed in this order on the article to be plated.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 60°C
Contact time with plating solution: 10 minutes
   - Electroless nickel-phosphorus plating film: phosphorus content 2 mass%, sulfur content 0.0003 mass%, thickness 4 µm
   - Electroless silver plating film: thickness 0.1 µm

### Example 6. Article to Be Plated: Electroless Nickel-Phosphorus Plating Film: Electroless Gold Plating Film

### Formation of Electroless Nickel-Phosphorus Plating Film

An article to be plated was brought into contact with an electroless nickel-phosphorus plating solution having the following composition under the following plating conditions to form an electroless nickel-phosphorus plating film on the article to be plated.

### Electroless Nickel-Phosphorus Plating Composition

As a basic composition, 22.5 g/L of nickel sulfate·6H₂O, 20 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 20 minutes

### Formation of Electroless Gold Plating Film

The electroless nickel-phosphorus plating film formed on the article to be plated was brought into contact with an electroless gold plating solution having the following composition under the following plating conditions to form an electroless gold plating film on the electroless nickel-phosphorus plating film.

### Electroless Gold Plating Composition

As a basic composition, 1.8 g/L of potassium gold cyanide and 15 g/L of sodium ethylenediamine tetraacetate were mixed. After adding other trace additives, the pH was adjusted to 5.0 with sulfuric acid and aqueous ammonia.

### Conditions for Electroless Gold Plating

Solution temperature: 85°C
Contact time with plating solution: 10 minutes

As described above, a plating film for metal sintering bonding was produced in which the following electroless nickel-phosphorus plating film and electroless gold plating film were formed in this order on the article to be plated.
- Electroless nickel-phosphorus plating film: phosphorus content 4 mass%, sulfur content 0.0003 mass%, thickness 4 µm
- Electroless gold plating film: thickness 0.05 µm

### Example 7. Article to Be Plated: Electroless Nickel-Phosphorus Plating Film: Electroless Gold Plating Film

The electroless nickel-phosphorus plating composition and plating conditions in Example 6 were changed to the following, thereby producing a plating film for metal sintering bonding in which the following electroless nickel-phosphorus plating film and electroless gold plating film were formed in this order on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes
   - Electroless nickel-phosphorus plating film: phosphorus content 2 mass%, sulfur content 0.0003 mass%, thickness 4 µm
   - Electroless gold plating film: thickness 0.05 µm

### Example 8. Article to Be Plated: Electroless Nickel-Phosphorus Plating Film: Electroless Palladium Plating Film-Electroless Silver Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

### Formation of Electroless Palladium Plating Film

The electroless nickel-phosphorus plating film formed on the article to be plated was brought into contact with an electroless palladium plating solution having the following composition under the following conditions to form an electroless palladium plating film on the electroless nickel-phosphorus plating film.

### Electroless Palladium Plating Composition

As a basic composition, 1.5 g/L of palladium chloride, 10 g/L of sodium formate, and 15 g/L of ethylenediamine were mixed. After adding other trace additives, the pH was adjusted to 6.0 with hydrochloric acid and aqueous ammonia.

### Conditions for Electroless Palladium Plating

Solution temperature: 55°C
Contact time with plating solution: 10 minutes

### Formation of Electroless Silver Plating Film

The electroless palladium plating film formed as described above was brought into contact with an electroless silver plating solution having the following composition under the following conditions to form an electroless silver plating film on the electroless palladium plating film.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 70°C
Contact time with plating solution: 20 minutes

As described above, a plating film for metal sintering bonding was produced in which the following electroless nickel-phosphorus plating film, electroless palladium plating film, and electroless silver plating film were formed in this order on the article to be plated.
- Electroless nickel-phosphorus plating film: phosphorus content 2 mass%, sulfur content 0.0003 mass%, thickness 4 µm
- Electroless palladium plating film: thickness 0.1 µm
- Electroless silver plating film: thickness 0.2 µm

### Example 9. Article to Be Plated: Electroless Nickel-Phosphorus Plating Film: Electroless Palladium Plating Film: Electroless Gold Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

### Formation of Electroless Palladium Plating Film

The electroless nickel-phosphorus plating film formed on the article to be plated was brought into contact with an electroless palladium plating solution having the following composition under the following conditions to form an electroless palladium plating film on the electroless nickel-phosphorus plating film.

### Electroless Palladium Plating Composition

As a basic composition, 1.5 g/L of palladium chloride, 10 g/L of sodium formate, and 15 g/L of ethylenediamine were mixed. After adding other trace additives, the pH was adjusted to 6.0 with hydrochloric acid and aqueous ammonia.

### Conditions for Electroless Palladium Plating

Solution temperature: 55°C
Contact time with plating solution: 10 minutes

### Formation of Electroless Gold Plating Film

The electroless palladium plating film formed as described above was brought into contact with an electroless gold plating solution having the following composition under the following conditions to form an electroless gold plating film on the electroless palladium plating film.

### Electroless Gold Plating Composition

As a basic composition, 1.8 g/L of potassium gold cyanide and 15 g/L of sodium ethylenediamine tetraacetate were mixed. After adding other trace additives, the pH was adjusted to 5.0 with sulfuric acid and aqueous ammonia.

### Conditions for Electroless Gold Plating

Solution temperature: 90°C
Contact time with plating solution: 10 minutes

As described above, a plating film for metal sintering bonding was produced in which the following electroless nickel-phosphorus plating film, electroless palladium plating film, and electroless gold plating film were formed in this order on the article to be plated.
- Electroless nickel-phosphorus plating film: phosphorus content 2 mass%, sulfur content 0.0003 mass%, thickness 4 µm
- Electroless palladium plating film: thickness 0.1 µm
- Electroless gold plating film: thickness 0.05 µm

### Example 10. Article to Be Plated: Electroless Nickel-Phosphorus Plating Film: Electroless Palladium-Phosphorus Plating Film: Electroless Silver Plating Film

### Formation of Electroless Nickel-Phosphorus Plating Film

An article to be plated was brought into contact with an electroless Ni-P plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

### Formation of Electroless Palladium-Phosphorus Plating Film

The electroless nickel-phosphorus plating film formed on the article to be plated was brought into contact with an electroless palladium-phosphorus plating solution having the following composition under the following conditions to form an electroless palladium-phosphorus plating film on the electroless nickel-phosphorus plating film.

### Electroless Palladium-Phosphorus Plating Composition

As a basic composition, 1.5 g/L of palladium chloride, 10 g/L of sodium hypophosphite, and 15 g/L of ethylenediamine were mixed. After adding other trace additives, the pH was adjusted to 6.0 with hydrochloric acid and aqueous ammonia.

### Conditions for Electroless Palladium-Phosphorus Plating

Solution temperature: 60°C
Contact time with plating solution: 10 minutes

### Formation of Electroless Silver Plating Film

The electroless palladium-phosphorus plating film formed as described above was brought into contact with an electroless silver plating solution having the following composition under the following conditions to form an electroless silver plating film on the electroless palladium-phosphorus plating film.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 70°C
Contact time with plating solution: 20 minutes

As described above, a plating film for metal sintering bonding was produced in which the following electroless nickel-phosphorus plating film, electroless palladium-phosphorus plating film, and electroless silver plating film were formed in this order on the article to be plated.
- Electroless nickel-phosphorus plating film: phosphorus content 2 mass%, sulfur content 0.0003 mass%, thickness 4 µm
- Electroless palladium-phosphorus plating film: phosphorus content 1 mass%, thickness 0.1 µm
- Electroless silver plating film: thickness 0.2 µm

### Example 11. Article to Be Plated: Electroless Nickel-Phosphorus Plating Film: Electroless Palladium-Phosphorus Plating Film: Electroless Gold Plating Film

### Formation of Electroless Nickel-Phosphorus Plating Film

An article to be plated was brought into contact with an electroless Ni-P plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

### Formation of Electroless Palladium-Phosphorus Plating Film

The electroless nickel-phosphorus plating film formed on the article to be plated was brought into contact with an electroless palladium-phosphorus plating solution having the following composition under the following conditions to form an electroless palladium-phosphorus plating film on the electroless nickel-phosphorus plating film.

### Electroless Palladium-Phosphorus Plating Composition

As a basic composition, 1.5 g/L of palladium chloride, 10 g/L of sodium hypophosphite, and 15 g/L of ethylenediamine were mixed. After adding other trace additives, the pH was adjusted to 6.0 with hydrochloric acid and aqueous ammonia.

### Conditions for Electroless Palladium-Phosphorus Plating

Solution temperature: 60°C
Contact time with plating solution: 10 minutes

### Formation of Electroless Gold Plating Film

The electroless palladium-phosphorus plating film formed as described above was brought into contact with an electroless gold plating solution having the following composition under the following conditions to form an electroless gold plating film on the electroless palladium-phosphorus plating film.

### Electroless Gold Plating Composition

As a basic composition, 1.8 g/L of potassium gold cyanide and 15 g/L of sodium ethylenediamine tetraacetate were mixed. After adding other trace additives, the pH was adjusted to 5.0 with sulfuric acid and aqueous ammonia.

### Conditions for Electroless Gold Plating

Solution temperature: 90°C
Contact time with plating solution: 10 minutes

As described above, a plating film for metal sintering bonding was produced in which the following electroless nickel-phosphorus plating film, electroless palladium-phosphorus plating film, and electroless gold plating film were formed in this order on the article to be plated.
- Electroless nickel-phosphorus plating film: phosphorus content 2 mass%, sulfur content 0.0003 mass%, thickness 4 µm
- Electroless palladium-phosphorus plating film: phosphorus content 1 mass%, thickness 0.1 µm
- Electroless gold plating film: thickness 0.05 µm

### Example 12. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 20 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 20 minutes

As described above, a plating film for metal sintering bonding was produced in which the following electroless nickel-phosphorus plating film was formed on the article to be plated.
- Electroless nickel-phosphorus plating film: phosphorus content 4 mass%, sulfur content 0.0003 mass%, thickness 4 µm

### Example 13. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 10 g/L of sodium hypophosphite, 20 g/L of glycine, 0.5 mg/L of lead acetate, and 0.1 mg/L of thiourea were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

As described above, a plating film for metal sintering bonding was produced in which the following electroless nickel-phosphorus plating film was formed on the article to be plated.
- Electroless nickel-phosphorus plating film: phosphorus content 2 mass%, sulfur content 0.0003 mass%, thickness 4 µm

### Example 14. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 8 g/L of sodium hypophosphite, 20 g/L of glycine, and 0.5 mg/L of lead acetate were mixed. After adding other trace additives, the pH was adjusted to 6.5 with sulfuric acid and ammonia water.

### Conditions for Electroless Nickel-Phosphorus Plating

Solution temperature: 90°C
Contact time with plating solution: 25 minutes

As described above, a plating film for metal sintering bonding was produced in which the following electroless nickel-phosphorus plating film was formed on the article to be plated.
- Electroless nickel-phosphorus plating film: phosphorus content 2 mass%, sulfur content 0.0001 mass%, thickness 4 µm

### Comparative Example 1. Article to Be Plated: Electroless Nickel-Phosphorus Plating Film: Electroless Silver Plating Film

### Formation of Electroless Nickel-Phosphorus Plating Film

An article to be plated was brought into contact with an electroless nickel-phosphorus plating solution having the following composition under the following plating conditions to form an electroless nickel-phosphorus plating film on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, and 0.5 mg/L of lead acetate were mixed. After adding other trace additives, the pH was adjusted to 4.5 with sulfuric acid and aqueous ammonia.

### Conditions for Electroless Nickel-Phosphorus Plating

Solution temperature: 90°C
Contact time with plating solution: 20 minutes

### Formation of Electroless Silver Plating Film

The electroless nickel-phosphorus plating film formed on the article to be plated was brought into contact with an electroless silver plating solution having the following composition under the following plating conditions to form an electroless silver plating film on the electroless nickel-phosphorus plating film.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 60°C
Contact time with plating solution: 20 minutes

As described above, a plating film for metal sintering bonding was produced in which the following electroless nickel-phosphorus plating film and electroless silver plating film were formed in this order on the article to be plated.
- Electroless nickel-phosphorus plating film: phosphorus content 10 mass%, sulfur content 0.0001 mass%, thickness 4 µm
- Electroless silver plating film: thickness 0.2 µm

### Comparative Example 2. Article to Be Plated: Electroless Nickel-Phosphorus Plating Film: Electroless Silver Plating Film

The electroless nickel-phosphorus plating composition and plating conditions in Comparative Example 1 were changed to the following, thereby producing a plating film for metal sintering bonding in which the following electroless nickel-phosphorus plating film and electroless silver plating film were formed in this order on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, 0.5 mg/L of lead acetate, and 0.1 mg/L of thiourea were mixed. After adding other trace additives, the pH was adjusted to 4.8 with sulfuric acid and aqueous ammonia.

### Conditions for Electroless Nickel-Phosphorus Plating

Solution temperature: 85°C
Contact time with plating solution: 20 minutes
   - Electroless nickel-phosphorus plating film: phosphorus content 7 mass%, sulfur content 0.0001 mass%, thickness 4 µm
   - Electroless silver plating film: thickness 0.2 µm

### Comparative Example 3. Article to Be Plated: Electroless Nickel-Phosphorus Plating Film: Electroless Silver Plating Film

The electroless nickel-phosphorus plating composition and plating conditions in Comparative Example 1 were changed to the following, thereby producing a plating film for metal sintering bonding in which the following electroless nickel-phosphorus plating film and electroless silver plating film were formed in this order on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, 0.5 mg/L of lead acetate, and 0.2 mg/L of thiourea were mixed. After adding other trace additives, the pH was adjusted to 4.5 with sulfuric acid and aqueous ammonia.

### Conditions for Electroless Nickel-Phosphorus Plating

Solution temperature: 85°C
Contact time with plating solution: 20 minutes
   - Electroless nickel-phosphorus plating film: phosphorus content 7 mass%, sulfur content 0.0003 mass%, thickness 4 µm
   - Electroless silver plating film: thickness 0.2 µm

### Comparative Example 4. Article to Be Plated: Electroless Silver Plating Film

### Formation of Electroless Silver Plating Film

An article to be plated was brought into contact with an electroless silver plating solution having the following composition under the following plating conditions to form an electroless silver plating film on the article to be plated.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 60°C
Contact time with plating solution: 20 minutes

As described above, a plating film for metal sintering bonding was produced in which the following electroless silver plating film was formed on the article to be plated.
- Electroless silver plating film: thickness 0.2 µm

### Comparative Example 5. Article to Be Plated: Electroless Silver Plating Film

### Formation of Electroless Silver Plating Film

An article to be plated was brought into contact with an electroless silver plating solution having the following composition under the following plating conditions to form an electroless silver plating film on the article to be plated.

### Electroless Silver Plating Composition

As a basic composition, 1.7 g/L of silver nitrate, 1.5 g/L of a water-soluble hydrazine derivative, 20 g/L of 1-methylhydantoin, and 0.5 mg/L of lead acetate were mixed. After adding other trace additives, the pH was adjusted to 10 with nitric acid and sodium hydroxide.

### Conditions for Electroless Silver Plating

Solution temperature: 70°C
Contact time with plating solution: 40 minutes

As described above, a plating film for metal sintering bonding was produced in which the following electroless silver plating film was formed on the article to be plated.
- Electroless silver plating film: thickness 1.0 µm

### Comparative Example 6. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, and 0.5 mg/L of lead acetate were mixed. After adding other trace additives, the pH was adjusted to 4.5 with sulfuric acid and aqueous ammonia.

### Conditions for Electroless Nickel-Phosphorus Plating

Solution temperature: 90°C
Contact time with plating solution: 20 minutes

As described above, a plating film for metal sintering bonding was produced in which the following electroless nickel-phosphorus plating film was formed on the article to be plated.
- Electroless nickel-phosphorus plating film: phosphorus content 10 mass%, sulfur content 0.0001 mass%, thickness 4 µm

### Comparative Example 7. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, 0.5 mg/L of lead acetate, and 0.1 mg/L of thiourea were mixed. After adding other trace additives, the pH was adjusted to 4.8 with sulfuric acid and aqueous ammonia.

### Conditions for Electroless Nickel-Phosphorus Plating

Solution temperature: 85°C
Contact time with plating solution: 20 minutes

As described above, a plating film for metal sintering bonding was produced in which the following electroless nickel-phosphorus plating film was formed on the article to be plated.
- Electroless nickel-phosphorus plating film: phosphorus content 7 mass%, sulfur content 0.0001 mass%, thickness 4 µm

### Comparative Example 8. Article to Be Plated: Electroless Nickel-Phosphorus Plating Film

### Formation of Electroless Nickel-Phosphorus Plating Film

An article to be plated was brought into contact with an electroless nickel-phosphorus plating solution having the following composition under the following conditions to form an electroless nickel-phosphorus plating film on the article to be plated.

### Electroless Nickel-Phosphorus Plating Composition

As a basic composition, 22.5 g/L of nickel sulfate·6H₂O, 25 g/L of sodium hypophosphite, 15 g/L of malic acid, 0.5 mg/L of lead acetate, and 0.2 mg/L of thiourea were mixed. After adding other trace additives, the pH was adjusted to 4.5 with sulfuric acid and aqueous ammonia.

### Conditions for Electroless Nickel-Phosphorus Plating

Solution temperature: 85°C
Contact time with plating solution: 20 minutes

As described above, a plating film for metal sintering bonding was produced in which the following electroless nickel-phosphorus plating film was formed on the article to be plated.
- Electroless nickel-phosphorus plating film: phosphorus content 7 mass%, sulfur content 0.0003 mass%, thickness 4 µm

### Comparative Example 9. Article to Be Plated As Is (Copper Bulk Material)

### Evaluation Method

The following evaluations were conducted on the Examples and Comparative Examples.

### Preparation of Sample for Measuring Bonding Strength of Silver Sintering Bonding

A semiconductor device was mounted on the plating film for metal sintering bonding produced in each of the Examples and Comparative Examples via a silver sintered material. Specifically, the silver sintered material used was a paste material made by mixing micron-sized silver flakes (produced by Fukuda Metal Foil & Powder Co., Ltd.) with an ether solvent (produced by Daicel Corporation). The semiconductor device used was a SiC dummy chip (3 mm × 3 mm × 1 mm) on which a titanium/silver sputtered film (0.1 µm/1.0 µm) was formed. The plating film for metal sintering bonding formed on the substrate and the SiC dummy chip on which the titanium/silver sputtered film was formed were bonded using the silver sintered material to prepare a sample for evaluating silver sintering bonding. The bonding conditions in Examples 1 to 11 and Comparative Examples 1 to 5 were no pressure, air atmosphere, 250°C, and 30 minutes, while the bonding conditions in Examples 12 to 14 and Comparative Examples 6 to 9 were 1 MPa pressure, air atmosphere, 250°C, and 30 minutes.

### Bonding Strength Measurement

The evaluation samples described above were each subjected to a shear test using a bond tester (Nordson DAGE 4000Plus) to measure the bonding strength between the plating film for metal sintering bonding and the silver sintered material. The shear test was carried out immediately after silver sintering bonding and after heat treatment at 300°C for 500 hours, and the initial adhesion and the adhesion after heat treatment were evaluated according to the following evaluation criteria.
30 MPa or more: good bonding strength
Less than 30 Mpa: poor bonding strength

The results are shown in Table 1.

**Table 1**

| | | Plating film composition | Electroless nickel-phosphorus plating film | | | Electroless palladium plating film | | Electroless silver plating film | Electroless gold plating film | Share test results | |
|---|---|---|---|---|---|---|---|---|---|---|---|
| | | | Phosphorus content (mass%) | Sulfur content (mass%) | Thickness (µm) | Phosphorus content (mass%) | Thickness (µm) | Thickness (µm) | Thickness (µm) | Initial adhesion | Adhesion after heat treatment |
| Ex. | 1 | Nickel-phosphorus/silver | 4 | 0.0003 | 4 | - | - | 0.2 | - | 40 | 33 |
| | 2 | | 2 | 0.0003 | 4 | - | - | 0.2 | - | 39 | 34 |
| | 3 | | 2 | 0.0001 | 4 | - | - | 0.2 | - | 47 | 46 |
| | 4 | | 2 | 0.0001 | 0.5 | - | - | 0.2 | - | 44 | 41 |
| | 5 | | 2 | 0.0003 | 4 | - | - | 0.1 | - | 41 | 38 |
| | 6 | Nickel-phosphorus/gold | 4 | 0.0003 | 4 | - | - | - | 0.05 | 39 | 32 |
| | 7 | | 2 | 0.0003 | 4 | - | - | - | 0.05 | 40 | 33 |
| | 8 | Nickel-phosphorus/palladium/silver | 2 | 0.0003 | 4 | 0 | 0.1 | 0.2 | - | 46 | 44 |
| | 9 | Nickel-phosphorus/palladium/gold | 2 | 0.0003 | 4 | 0 | 0.1 | - | 0.05 | 44 | 40 |
| | 10 | Nickel-phosphorus/palladium-phosphorus/silver | 2 | 0.0003 | 4 | 1 | 0.1 | 0.2 | - | 47 | 43 |
| | 11 | Nickel-phosphorus/palladium-phosphorus/gold | 2 | 0.0003 | 4 | 1 | 0.1 | - | 0.05 | 44 | 39 |
| | 12 | Nickel-phosphorus | 4 | 0.0003 | 4 | - | - | - | - | 36 | 31 |
| | 13 | | 2 | 0.0003 | 4 | - | - | - | - | 37 | 31 |
| | 14 | | 2 | 0.0001 | 4 | - | - | - | - | 42 | 40 |
| Comp. Ex, | 1 | Nickel-phosphorus/silver | 10 | 0.0001 | 4 | - | - | 0.2 | - | 38 | 20 |
| | 2 | | 7 | 0.0001 | 4 | - | - | 0.2 | - | 39 | 23 |
| | 3 | | 7 | 0.0003 | 4 | - | - | 0.2 | - | 36 | 21 |
| | 4 | Silver | - | - | - | - | - | 0.2 | - | 29 | 15 |
| | - - 5 | | - | - | - | - | - | 1.0 | - | 32 | 19 |
| | 6 | Nickel-phosphorus | 10 | 0.0001 | 4 | - | - | - | - | 33 | 19 |
| | 7 | | 7 | 0.0001 | 4 | - | - | - | - | 34 | 18 |
| | 8 | | 7 | 0.0003 | 4 | - | - | - | - | 30 | 20 |
| | 9 | No plating film (copper bulk material) | - | - | - | - | - | - | - | 20 | 9 |

From the results in Table 1, Examples 1 to 14 had excellent initial adhesion and adhesion after heat treatment, and the bonding strength did not decrease significantly even after heat treatment, revealing that they had excellent heat resistance and thermal shock resistance, making them plating films suitable for metal sintering bonding.

In contrast, in Comparative Examples 1 to 9, the adhesion after heat treatment was significantly lower than the initial adhesion, revealing that they had inferior heat resistance and thermal shock resistance compared to Examples 1 to 14.

## Claims

1. A plating film for metal sintering bonding having (A) an electroless nickel-phosphorus plating film,
the electroless nickel-phosphorus plating film (A) having a phosphorus content of 4 mass% or less based on 100 mass% of the electroless nickel-phosphorus plating film.

2. The plating film for metal sintering bonding according to claim 1, wherein the electroless nickel-phosphorus plating film (A) has a sulfur content of less than 0.0005 mass% based on 100 mass% of the electroless nickel-phosphorus plating film.

3. The plating film for metal sintering bonding according to claim 1, wherein the electroless nickel-phosphorus plating film (A) has a sulfur content of 0.0001 mass% or less based on 100 mass% of the electroless nickel-phosphorus plating film.

4. The plating film for metal sintering bonding according to claim 1, wherein the electroless nickel-phosphorus plating film (A) has a thickness of 0.1 to 20 µm.

5. The plating film for metal sintering bonding according to claim 1, further having (B) an electroless silver plating film or an electroless gold plating film on the electroless nickel-phosphorus plating film (A).

6. The plating film for metal sintering bonding according to claim 5, wherein the electroless silver plating film or electroless gold plating film (B) has a thickness of 0.02 to 2 µm.

7. The plating film for metal sintering bonding according to claim 5, further having (C) a barrier metal layer between the electroless nickel-phosphorus plating film (A) and the electroless silver plating film or electroless gold plating film (B) .

8. The plating film for metal sintering bonding according to claim 7, wherein the barrier metal layer (C) is an electroless palladium plating film or an electroless palladium-phosphorus plating film.

9. The plating film for metal sintering bonding according to claim 1, which is for a metal sintered material containing silver and/or copper.

10. A method for manufacturing a plating film for metal sintering bonding, which forms a plating film for metal sintering bonding on a substrate,
the method comprising (1) step 1 of bringing an electroless nickel-phosphorus plating solution into contact with a surface of a substrate to form (A) an electroless nickel-phosphorus plating film on the substrate,
the electroless nickel-phosphorus plating film (A) having a phosphorus content of 4 mass% or less based on 100 mass% of the electroless nickel-phosphorus plating film.

11. The manufacturing method according to claim 10, further comprising (2) step 2 of bringing an electroless silver plating solution or an electroless gold plating solution into contact with a surface of the electroless nickel-phosphorus plating film to form (B) an electroless silver plating film or an electroless gold plating film on the electroless nickel-phosphorus plating film (A).

12. A semiconductor mounting substrate comprising a plating film for metal sintering bonding laminated on a substrate, wherein the plating film for metal sintering bonding has (A) an electroless nickel-phosphorus plating film,
wherein a semiconductor device is provided on the plating film for metal sintering bonding via a metal sintered material layer, and
wherein the electroless nickel-phosphorus plating film (A) has a phosphorus content of 4 mass% or less based on 100 mass% of the electroless nickel-phosphorus plating film.
